# EUROPÄISCHE PATENTSCHRIFT

(11) **EP 0 491 252 B1**
(45) Veröffentlichungstag und Bekanntmachung des Hinweises auf die Patenterteilung: **15.11.1995**
(21) Anmeldenummer: 91120985.6
(22) Anmeldetag: 06.12.1991
(51) Int. Cl.: H04Q 1/14, H02B 1/20

(54) **Drahtführungselement für eine Verteilereinheit in Telekommunikationsanlagen**
Wire guiding element for a distributor in telecommunication installations
Elément de guidage de fil d'un distributeur pour installations de télécommunication

(30) Priorität: 19.12.1990 DE 9017155 U
(43) Veröffentlichungstag der Anmeldung: 24.06.1992
(73) Patentinhaber: SIEMENS AKTIENGESELLSCHAFT, 80333 München (DE)
(72) Erfinder: Knoll, Rudolf, Dipl.-Ing., W-8137 Berg 3 (DE); Störk, Peter, Ing., W-8196 Eurasburg (DE)

(56) Entgegenhaltungen:
- EP-A- 0 109 881
- DE-U- 9 017 155
- FR-A- 1 604 898
- US-A- 4 278 315
- US-A- 4 470 102

## Beschreibung

Die Erfindung betrifft eine Verteilereinheit mit Drahtführungselement für Telekommunikationsanlagen, die aus einem für die Aufnahme der Anschlußleisten zum Anschließen und Verbinden von abgehenden und ankommenden Leitungen dienenden länglichen und im wesentlichen U-förmig ausgebildeten Trägerteil besteht, das seinerseits vermittels eines mit ihm fest verbindbaren Halteelementes bei längsseitig vertikaler Ausrichtung in einen gebrauchfertigen Montagezustand gebracht wird, und wobei eine Erweiterung durch mindestens eine seitlich anzubringende gleichartige Verteilereinheit möglich ist und zwischen jeweils solch benachbart angeordneten Verteilereinheiten Leitungsadern verlaufen und auf jede Verteilereinheit eine separate Abdeckhaube aufsetzbar ist.

Eine solche Verteilereinheit dient dazu Rangierleitungen von jedem beliebigen Anschlußpunkt der Anschlußleisten für ankommende Leitungen zu jedem beliebigen Anschlußpunkt der Anschlußleisten für die beispielsweise zu der Vermittlungseinrichtung führenden abgehenden Leitungen verlegen zu können. Auch bei zunehmender Verdrahtungsdichte in modernen Verteileranlagen muß eine übersichtliche Verdrahtungsordnung eingehalten werden. Zu einer solchen geordneten Verlegung von Leitungen werden beispielsweise Haken- oder bügelförmige Drahtführungselemente im Bereich der vorgesehenen Drahtführungsbahnen angeordnet. Bei entsprechend großen Teilnehmerzahlen wird eine Verteilereinheit durch gegebenfalls auch beidseitig unmittelbar benachbart anzuordnende gleichartige Verteilereinheiten erweitert.

Die Aufgabe der Erfindung besteht darin, eine optimale Führung der zwischen den Verteilereinheiten zu verlegenden Leitungen durch entsprechend abgestimmte und plazierte Führungselemente zu ermöglichen. Dies wird dadurch erreicht, daß das Drahtführungselement als Kunststoffteil ausgebildet ist und zur Bildung eines Querkanals zwischen zwei unmittelbar benachbarten Verteilereinheiten einen an zwei gegenüberliegenden Seiten offenen Hohlkörper darstellt, dessen unterer Wandbereich nach außen zeigende Führungszapfen aufweist, mit denen es an der Stirnkante eines jeden Schenkels des nach vorne offenen Trägerteils unmittelbar aufsteckbar ist und daß mit Hilfe von an der Rückseite angebrachten Befestigungselementen eine mechanische Verbindung mit dem über das Trägerteil in Längsrichtung hinausragenden Haltelement erfolgt.

Das Drahtführungselement kann kostengünstig als Kunststoff hergestellt und in einfacher Weise ausreichend stabil in dem Stirnkantenbereich befestigt werden. Neben den durch den Hohlkörper vorgegebenen Raum können an dem Drahtführungselement durch an der Außenwand angeformte stiftförmige oder hakenförmige Ansätze zusätzliche Leitungen geführt werden.

Aus der US-A-4 278 315 sind bereits Drahtführungselemente zur Leitungsführung zwischen benachbarten Verteilereinheiten bekannt. Jedoch sind diese bekannten Führungselemente lediglich zum Zusammenhalten der zwischen zwei benachbarten Verteilereinheiten vertikal geführten Leitungen geeignet und dienen in erster Linie lediglich als Abstandselemente.

Gemäß einer Weiterbildung der Erfindung ist als Befestigungselement an der Rückseite eine hakenartige Ausformung vorgesehen, die sich in einem fingerartigen, federnden Lappen fortsetzt. Im Bereich eines jeden Schenkels ist an der als Haltelement dienenden Platte ein Ausschnitt vorgesehen. Zur mechanischen Verbindung umgreift die hakenartige Ausformung die untere Kante dieses Ausschnittes und der federnde Lappen schnappt unterhalb der oberen Kante dieses Ausschnittes ein.

Das auf der Stirnkante des Trägerteils plazierte Drahtführungselement wird also in äußerst einfacher Weise ausreichend stabil gehalten. Nach dem Einschnappen des federnden Lappens ist das Führungselement verriegelt.

Diese Verriegelung wird erfindungsgemäß durch eine am federnden Ende des Lappens angeformte Rippe begünstigt. Gemäß einer Weiterbildung der Erfindung weist das nach dem Befestigen mit seinen offenen Seiten in Richtung der einander benachbarten Verteilereinheiten ausgerichtete Drahtführungselement an der von vorne zugänglichen Wandfläche einen in dieser gleichen Richtung zeigenden Schlitz auf.

Dadurch können die Leiter in einfacher Weise in das Drahtführungselement eingelegt werden.

Eine besondere Einführungserleichterung ergibt sich dadurch, daß bei einem rechteckförmigen Querschnitt des Hohlkörpers der Schlitz im Bereich der oberen Kante der aufeinanderstoßenden oberen und vorderen Wandteile vorgesehen ist.

Die Einlegung der Leitungen wird zusätzlich noch dadurch erleichtert, daß zur Bildung des genannten Schlitzes der obere Teil der vorderen Wandfläche in Richtung zur Oberseite hin schräg nach innen weist.

Eine Weiterbildung der Erfindung besteht darin, daß das Drahtführungselement in der durch die offenen Seiten bestimmten Querrichtung eine solche Ausdehnung aufweist, daß es zumindest über die durch eine Abdeckhaube jeweils vorgegebenen seitlichen Grenzen hinaus in die unmittelbar benachbarte Verteilereinheit hineingreift, wobei in jeder Seitenwand der Abdeckhaube ein an die Abmessungen des Drahtführungselementes angepaßter Ausschnitt vorgesehen ist.

Damit werden also in einfacher Weise die zwischen den benachbarten Verteilereinheiten verlegten Leitungsdrähte im Bereich dieser Abdeckung vor Verletzung geschützt.

Weitere vorteilhafte Ausgestaltung der Erfindung sind den restlichen Schutzansprüchen zu entnehmen.

Im folgenden wird die Erfindung anhand eines in der Zeichnung dargestellten Ausführungsbeispiels näher erläutert. Es zeigen
FIG 1 die Expolsionsdarstellung einer Verteilereinheit,
FIG 2 und 3 zwei Ansichten des Drahtführungselementes
FIG 4 einen vergrößerten Ausschnitt der Befestigungselemente und
FIG 5 die Draufsicht auf die Vorderseite einer Verteilereinheit.

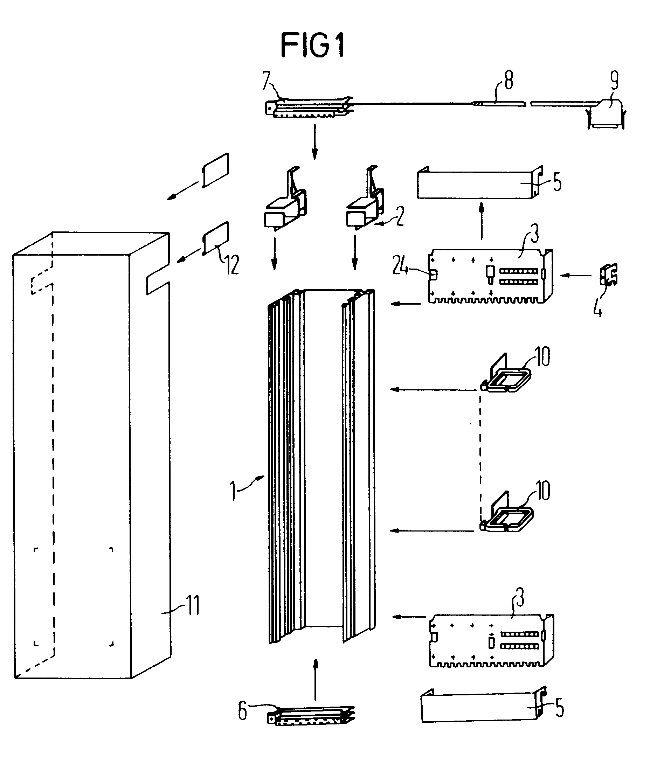

Die z.B. zur Montage an einer Wand vorgesehene Grundeinheit besteht gemäß FIG 1 aus dem Trägerteil 1 und der mit ihr im oberen und unteren Bereich verbindbaren Platte 3. Das Tragerteil ist U-förmig ausgebildet und als Strangpreßprofil hergestellt, wobei dann jeweils eine beliebige Längenabmessung durch einfaches Abtrennen von der "Meterware" möglich ist. Durch eine entsprechende Ausgestaltung der freien Kante eines jeden Schenkels dieser U-Form des Trägerteils können die Anschlußleisten 6 bzw. 7 an diesen Kanten befestigt werden. Hierzu kann beispielsweise die freie Kante des einen Schenkels eine durchgehende, ggf. leicht nach innen geneigte vollzylindrische Form aufweisen. Auf diese vollzylindrische Form wird dann eine Anschlußleiste, die mit einem darin angepaßten Ausschnitt stirnseitig versehen ist, aufgesteckt. Der andere Schenkel weist an der freien Kante einen durchgehenden Schraubkanal auf. Nach dem Aufstecken der Anschlußleiste auf die als vollzylindrische Form ausgebildete Kante des anderen Schenkels ist an einer beliebigen längsseitigen Stelle des Trägerteils die jeweilige Anschlußleiste z.B. mit einem darin angesetzten Flansch auf die Kanten des Schraubkanals aufzusetzen. Mit einer selbstschneidenden Schraube kann die Anschlußleiste in dem Schraubkanal bei einer entsprechenden Lochung des Flansches an dem Trägerteil 1 befestigt werden. Das Trägerteil nimmt in dieser geschilderten Weise zur Bildung eines Verteilerblockes eine Mehrzahl von Anschlußleisten 6 bzw. 7 auf, die längsseitig aneinandergereiht sind. Es können beispielsweise als Anschlußleisten 7 solche verwendet werden, bei denen Anschlußelemente an den sich gegenüberliegenden Längsseiten vorgesehen sind. Danach sind z.B. die Anschlußelemente für die selten zu ändernden und zur Vermittlungseinrichtung führenden Leitungen auf der Rückseite der Leiste angeodnet. Diese als Kabel 8 abgehenden Leitungen der Internseite können bereits werkseitig angeschlossen werden. Zur Kontaktierung mit den in der Vermittlungseinrichtung vorhandenen Gegenkontakten sind sie mit einer Steckeinrichtung 9 verbunden. Die Anschlußelemente für die Externseite, also für die Teilnehmerleitungen sind nach wie vor an der vorderen Bedienungsseite der Leiste vorgesehen. Diese Anschlußelemente sind somit leicht zugänglich, so daß Änderungen in der Belegung der Leiste ohne weiteres vorgenommen werden können. Zur geordneten Führung der Leitungen sind an dem einen Schenkel des U-förmigen Profils bügel- oder hakenförmige Drahtführungselemente 10 in einfacher Weise aufzuschnappen. Mit diesen Elementen wird somit ein senkrechter Kanal zur Führung der Leitungen zur Verfügung gestellt.

Zur Wandbefestigung wird das Trägerteil 1 an seinem oberen und seinem unteren Ende mit einer C-förmig ausgestalteten Platte 3 verschraubt. Diese Platte ragt sowohl in Längsrichtung als auch an einer Seite über das Trägerteil 1 hinaus. Mit einer solchen Platte kann nach der Montage ein bestimmter Abstand zwischen dem Verteilerblock und einer Wandfläche eingehalten werden. In diesem Wandabstandsbereich sind Kabel zu führen. Die in dem seitlich überstehenden Teil der Platte 3 vorhandenen Lochungen dienen dazu mittels entsprechender Schellen 4 die seitlich durch die Drahtführungselemente 10 gehaltenen Kabel zu befestigen. Die betreffenden Leiter werden dann beispielsweise nach ihrer Umlenkung von oben in den durch das Trägerteil 1 vorgegebenen Raum zu den Anschlußleisten 7 geführt. Weiterhin zeigt die Darstellung der FIG 1 ein schienenartiges Element 5, das zur Befestigung von Zusatzeinbauten dient. Es wird in seiner Normalposition an der oberen Kante der Platte 3 eingehängt. Eine Verteilereinheit kann nach ihrer endgültigen Bestückung mit einer Abdeckhaube 11 versehen werden. Diese Abdeckhaube 11 weist beidseitig Freinehmungen auf, die mit eingeschobenen und verrasteten Kunststoffteilen 14 abzudecken sind. Diese Freinehmungen dienen dazu, Querkanäle zu ermöglichen, wenn eine Verteilereinheit durch eine jeweils seitlich unmittelbar benachbart anzuordnende gleichartige Verteilereinheit erweitert wird.

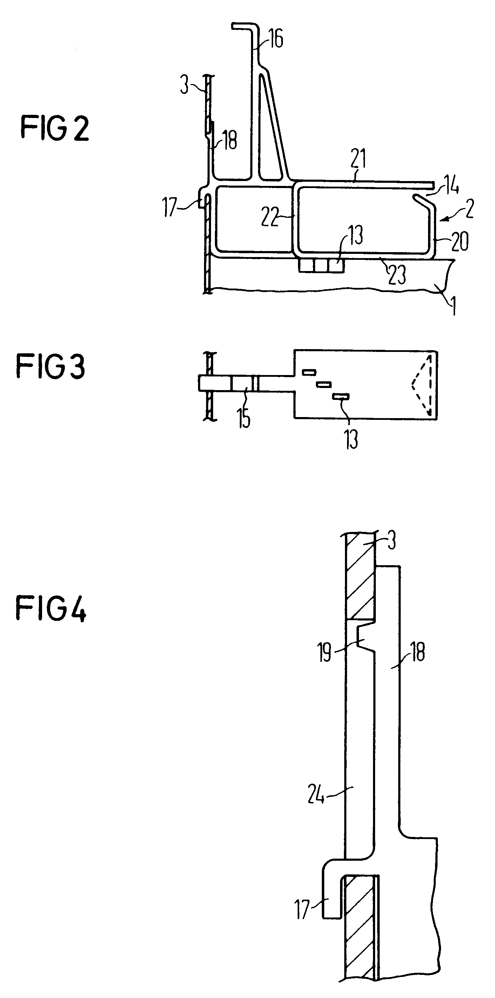

Die Figuren 2 bis 4 zeigen Einzelheiten des auf die Stirnkante des Trägerteils 1 aufsetzbaren Drahtführungselementes 2. In dem durch seine Wände 20 bis 23 umschlossenen rechteckförmigen Hohlraum werden Leitungen hindurchgeführt bzw. von vorne durch den Schlitz 14 hindurch in den Hohlkörper eingebracht. Zur Bildung des an der oberen Vorderseite vorhandenen Schlitzes 14 wird die frei Oberkante der Wandfläche 20 zur oberen Begrenzungsfläche hin schräg nach innen geführt. Die Kanten des nach innen weisenden Teils laufen mittig spitzwinklig aus, wie der FIG 3 zu entnehmen ist. Der vordere Wandteil 20 ist federnd ausgebildet, so daß in Verbindung mit der Gestaltung des Schlitzes 14 das Einbringen von Kabel bzw. Leitungen problemlos möglich ist.

Zum Anbringen des Drahtführungselementes 2 an der Stirnkante eines Schenkels des Trägerteils 1 dienen zum einen die an seiner Unterseite vorhandenen Führungszapfen 13 sowie der an seiner Rückseite angeordnete Haken 17 in Verbindung mit dem federnden Lappen 18. Im Ausführungsbeispiel sind diese letztgenannten Befestigungelemente an einem Steg 15 angeformt, der seinerseits von der rückseitigen Wand 22 des Hohlkörpers ausgeht. Abhängig von der gewünschten Dimensionierung dieses Hohlkörpers könnten diese Befestigungselemente auch unmittelbar am rückseitigen Wandteil 22 befestigt sein.

Die mehrfach vorgesehenen Führungszapfen 13 sind entsprechend der Ausformung des Schenkels des Trägerteils gegeneinander versetzt. Beim Aufsetzen des Drahtführungselementes 2 umgreifen diese Zapfen die obere Kante des Profils. Der Haken 17 wird in den Ausschnitt 24, der in der Platte 3 vorgesehen ist eingeführt. Das Drahtführungselement 2 wird so lange nach unten bewegt, bis der Haken 17 die untere Kante des Ausschnittes 24 umgreift. Bei dieser Aufsetzbewegung wird der federnde Lappen 18 zunächst an der entsprechenden Wand der Platte 3 entlanggeführt, wobei er sich mit einer bestimmten Federkraft abstützt. Mit Erreichen der Endposition schnappt der federnde Lappen 18 an der oberen Kante des Ausschnittes 24 mit seiner an ihm angesetzten Rippe 19 in den Ausschnitt 24 ein. Damit wird eine Verriegelung erreicht, so daß das Drahtführungselement erst nach einer einfachen manuellen Entriegelung abnehmbar ist. Die eingenommene Endposition ist somit durch die genannten Befestigungselemente in Verbindung mit den Führungszapfen 13 gesichert.

In der FIG 4 sind die aus dem Haken 17 und dem federnden Lappen 18 bestehenden Befestigungselemente mit denen die Befestigung an der Platte 3 vorgenommen wird in einem vergrößerten Maßstab ausschnittsweise nochmals dargestellt.

An der Oberseite des Drahtführungselementes 2 ist zusätzlich eine hakenförmige Ausformung 16 vorgesehen, die einen bestimmten Abstand zur Platte 3 aufweist. In diesem Raum zwischen der Platte 3 und der hakenartigen Ausformung 16 können gleichfalls Kabel bzw. Leiter geführt werden. Damit wird z.B. verhindert, daß derartige Leiter zur Vorderseite hin abkippen.

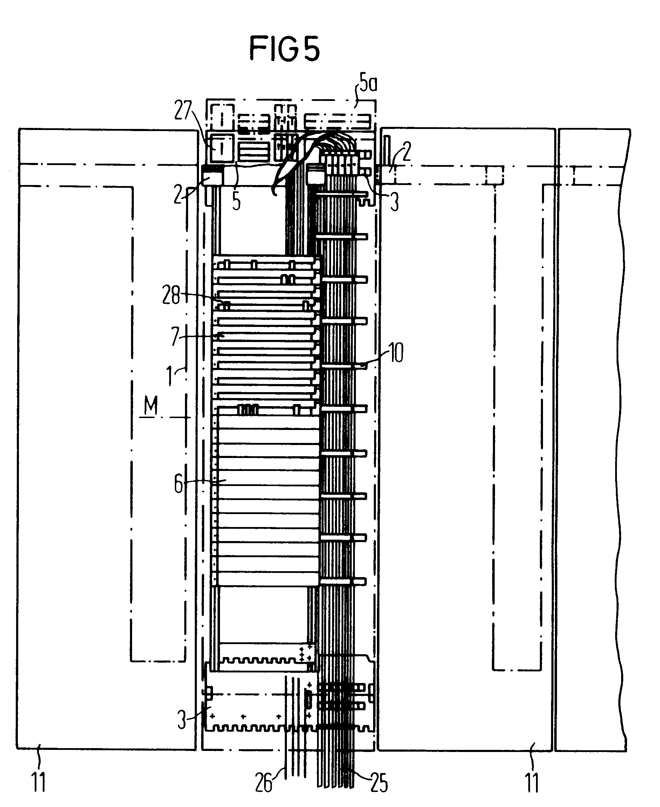

Bei der in der FIG 5 ohne Abdeckhaube dargestellten Verteilereinheit ist ihre Bestückung mit den Einzelelementen angedeutet. Ausgehend von einer vorgegebenen Markierungslinie M ist oberhalb dieser Linie ein Feld von Anschlußleisten 7 vorhanden, die z.B. als Trennleisten der Internseite zugeordnet sind. Die an diesen Leisten anzuschließenden Leiter 25 führen demnach zur Vermittlungseinrichtung. Diese Leitungen werden wie bereits erwähnt an der über das Profil des Trägerteils 1 seitlich hinausreichenden Platte 3 z.B. mittels Federschellen 4 befestigt. Das Einlegen, Kontaktieren und Befestigen auf den Platten 3 ist vom Prifil weg vorgesehen, um bei einer späteren Erweiterung ein Durchfädeln zu vermeiden. Von der Befestigungsstelle an der oberen Platte 3 werden die einzelnen Leiter von oben zu den Trennleisten 7 geführt und mit ihren Anschlußelementen verbunden. Diese Anschlußelemente sind in der Regel als Klemmelemente ausgebildet, die den abisolierfreien Anschluß der elektrischen Leiter gestatten. Die zur Vermittlungseinrichtung führenden Leiter können beispielsweise an den an der Unterseite der Trennleiste vorgesehenen Anschlußelementen verbunden sein. Die an ihrer Oberseite vorhandenen Anschlußelemente sind dann für die im Rahmen der sogenannten Rangierung zu belegenden variablen Anschlüsse vorhanden. Diese sind von vorne gut erreichbar. An die der Internseite zugeordneten Anschlußleisten 7 sind bedarfsweise Schutzstecker 28 aufzustecken.

Es wird nun mit den Leitern des Internkabels 26 nicht unmittelbar rangiert, sondern die Leiter werden an Anschlußelemente der unterhalb der Markierungslinie M angeordneten Rangierleisten 6 angeklemmt. Es wird dann die eigentliche Rangierung zwischen den jeweils an der Vorderseite vorhandenen Anschlußelementen der Trennleisten und den Anschlußelementen der Rangierleisten vorgenommen. Durch die von einer bestimmten Markierung M aus erfolgende Teilung der Leistenfelder wird die z.B. nach und nach entsprechend dem Anwachsen der Teilnehmerzahl vorzunehmende Erweiterung erleichtert, wenn von dieser Markierung weg nach unten bzw. nach oben ausgebaut wird. Die Anschlußleisten sind unabhängig von den Drahtführungen und nachträglich einzusetzen.

Oberhalb des Trägerteils 1 wird an der rückseitig damit verschraubten Platte 3 die mit Zusatzbauteilen 27 bestückte Schiene 5 eingehängt. Sie ist abgebrochen dargestellt, so daß die normalerweise von ihr überdeckten Leiter sichtbar sind. Die Position 5a dieser Schiene entspricht der durch einfaches Aufstecken auf die Kante der Platte 3 einnehmbaren Parkposition.

Im Ausführungsbeispiel nach der FIG 4 sind an die ohne Abdeckhaube dargestellte Verteilereinheit an beiden Seiten weitere Verteilereinheiten vorgesehen. Die Drahtführungselemente 2, die z.B. jeweils an der Stirnkante des der angrenzenden Verteilereinheit unmittelbar benachbarten Schenkels aufgesetzt sind, greifen etwas in die jeweils andere Verteilereinheit ein. Dadurch können die zwischen den einzelnen Verteilereinheiten verlaufenden Leitungen durch die Ausschnittskanten der jeweiligen Abdeckhauben 11 nicht verletzt werden.

## Patentansprüche

1. Verteilereinheit mit Drahtführungselement (2) für Telekommunikationsanlagen, wobei die Verteilereinheit aus einem für die Aufnahme der Anschlußleisten (6, 7) zum Anschließen und Verbinden von abgehenden und ankommenden Leitungen dienenden länglichen und im wesentlichen U-förmig ausgebildeten Trägerteil (1) besteht, das seinerseits vermittels eines mit ihm fest verbindbaren Halteelementes bei längsseitig vertikaler Ausrichtung in einen gebrauchsfertigen Montagezustand gebracht wird, und wobei eine Erweiterung durch mindestens eine seitlich anzubringende gleichartige Verteilereinheit möglich ist und zwischen jeweils solch benachbart angeordneten Verteilereinheiten Leitungsadern verlaufen und auf jede Verteilereinheit eine separate Abdeckhaube (11) aufsetzbar ist,
**dadurch gekennzeichnet**,
daß das Drahtführungselement als Kunststoffteil ausgebildet ist und zur Bildung eines Querkanals zwischen zwei unmittelbar benachbarten Verteilereinheiten einen an zwei gegenüberliegenden Seiten offenen Hohlkörper dargestellt, dessen unterer Wandbereich (23) nach außen zeigende Führungszapfen (13) aufweist, mit denen es an der Stirnkante eines jeden Schenkels des nach vorne offenen Trägerteils (1) unmittelbar aufsteckbar ist und daß mit Hilfe von an der Rückseite angebrachten Befestigungselementen (17, 18) eine mechanische Verbindung mit dem über das Trägerteil (1) in Längsrichtung hinausragendem Haltelement (3) erfolgt.

2. Verteilereinheit mit Drahtführungselement nach Anspruch 1,
**dadurch gekennzeichnet,**
daß als Befestigungselement an der Rückseite eine hakenartige Ausformung (17) vorgesehen ist, die sich in einem fingerartigen, federnden Lappen (18) fortsetzt, daß im Bereich eines jeden Schenkels des Trägerteils (1) an der als Halteelement dienenden Platte (3) ein Ausschnitt (24) vorgesehen ist, daß zur mechanischen Verbindung die hakenförmige Ausformung (17) die untere Kante des Ausschnittes (24) umgreift und der federnde Lappen in den Ausschnitt unterhalb der oberen Kante des Ausschnittes (24) einschnappt.

3. Verteilereinheit mit Drahtführungselement nach Anspruch 2,
**dadurch gekennzeichnet,**
daß im Endbereich des federnden Lappens (18) eine nach außen weisende Rippe (19) angeformt ist.

4. Verteilereinheit mit Drahtführungselement nach Anspruch 1 oder 2,
**dadurch gekennzeichnet**,
daß es nach dem Befestigen mit seinen offenen Seiten in Richtung der einander benachbarten Verteilereinheiten ausgerichtet ist und daß es an der von vorne zugänglichen Wandfläche (20) einen in dieser Richtung zeigenden Schlitz (14) aufweist.

5. Verteilereinheit mit Drahtführungselement nach den Ansprüchen 1 und 4,
**dadurch gekennzeichnet,**
daß der Hohlkörper einen rechteckförmigen Querschnitt aufweist und daß der Schlitz (14) im Bereich der oberen Kante der aufeinanderstoßenden oberen (21) und vorderen Wandteile (20) vorgesehen ist.

6. Verteilereinheit mit Drahtführungselement nach Anspruch 5,
**dadurch gekennzeichnet,**
daß zur Bildung des genannten Schlitzes (14) der obere Teil der vorderen Wandfläche in Richtung zur Oberseite (21) hin schräg nach innen weist.

7. Verteilereinheit mit Drahtführungselement nach einem der vorhergehenden Ansprüche,
**dadurch gekennzeichnet,**
daß es in dieser durch die offenen Seiten bestimmten Querrichtung eine solche Ausdehnung aufweist, daß es zumindest über die durch eine Abdeckhaube (11) jeweils vorgegebenen zeitlichen Grenzen hinaus in die einander benachbarten Verteilereinheiten hineingreift, wobei in jeder Seitenwand einer Abdeckhaube ein an die Abmessungen des Drahtführungselementes angepaßter Ausschnitt vorgesehen ist.

8. Verteilereinheit mit Drahtführungselement nach Anspruch 1,
**dadurch gekennzeichnet,**
daß an der unteren Wandfläche (23) wenigstens zwei Führungszapfen (13) angeformt sind, die entsprechend dem vorgeformten Profil gegeneinander seitlich versetzt sind und in seiner Endposition die Kante umgreifen.

9. Verteilereinheit mit Drahtführungselement nach Anspruch 1,
**dadurch gekennzeichnet,**
daß in seinem rückseitigen Bereich eine hakenförmige und angenähert senkrecht nach oben weisende Ausformung (16) ausgebildet ist.

10. Verteilereinheit mit Drahtführungselement nach einem der vorhergehenden Ansprüche,
**dadurch gekennzeichnet,**
daß das vordere Wandteil (20) zusätzlich zur Anbringung einer Beschriftung dient.

## Revendications

1. Répartiteur comportant un élément guide-fil (2) pour des installations de télécommunication, le répartiteur étant constitué par une partie de support allongée (1), agencée essentiellement en forme de U, qui sert à loger les barrettes de connexion (6,7) pour le raccordement et la liaison de lignes de départ et de lignes d'arrivée et qui, pour sa part, est placée dans un état de montage prêt pour l'utilisation, avec une orientation verticale de ses côtés longitudinaux, au moyen d'un élément de retenue qui peut être relié fermement à cet élément de support, et dans lequel une extension avec au moins un répartiteur identique devant être disposé latéralement est possible et des conducteurs de lignes s'étendent entre des répartiteurs respectifs disposés dans un tel voisinage, et un capot de fermeture séparé (11) peut être monté sur chaque répartiteur,
caractérisé par le fait
que l'élément guide-fil est réalisé sous la forme d'une pièce en matière plastique et, pour la formation d'un canal transversal entre deux répartiteurs directement voisins, comporte un corps creux ouvert sur deux côtés opposés et dont l'élément de paroi inférieur (23) comporte des tétons de guidage (13) dirigés vers l'extérieur, au moyen desquels il peut être enfiché directement sur le bord frontal de chaque branche de l'élément de support (1) ouvert vers l'avant et qu'une liaison mécanique avec l'élément de retenue (3), qui fait saillie au-delà de l'élément de support (1) dans la direction longitudinale, s'effectue à l'aide d'éléments de fixation (17,18) montés sur la face arrière.

2. Répartiteur comportant un élément guide-fil, caractérisé par le fait qu'il est prévu, comme élément de fixation sur la face arrière, une partie conformée en crochet (17), qui se prolonge par une patte en forme de doigt élastique (18), qu'une découpe (22) est prévue dans la zone de chaque branche de l'élément de support (1) au niveau de la plaque (3) utilisée comme élément de retenue et que pour la liaison mécanique, la partie conformée en crochet (17) s'engage autour du bord inférieur de la découpe (24) et que la patte élastique s'encliquette dans la découpe (24) au-dessous du bord supérieur de cette dernière.

3. Répartiteur comportant un élément guide-fil suivant la revendication 2, caractérisé par le fait qu'une nervure (19), qui fait saillie extérieurement, est formée dans la zone d'extrémité de la patte élastique (18).

4. Répartiteur comportant un élément guide-fil suivant la revendication 1 ou 2, caractérisé par le fait que l'élément guide-fil est orienté avec ses côtés ouverts en direction des répartiteurs qui sont réciproquement voisins, après la fixation, et qu'il comporte, au niveau de la surface de paroi (20) accessible à partir de l'avant, une fente (14) tournée dans cette direction.

5. Répartiteur comportant un élément guide-fil suivant les revendications 1 et 4, caractérisé par le fait que le corps creux possède une section transversale de forme rectangulaire et que la fente (14) est prévue dans la zone du bord supérieur de l'élément de paroi supérieur (21) et de l'élément de paroi avant (20), qui sont en aboutement réciproque.

6. Répartiteur comportant un élément guide-fil suivant la revendication 5, caractérisé par le fait que pour la formation de ladite fente (14), la partie supérieure de la surface de paroi avant s'étend obliquement vers l'intérieur en direction de la face supérieure (21).

7. Répartiteur comportant un élément guide-fil suivant l'une des revendications précédentes, caractérisé par le fait que l'élément guide-fil possède, dans cette direction transversale déterminée par les côtés ouverts, une étendue telle qu'il s'engage au moins au-delà des limites latérales, respectivement prédéterminées par un capot de revêtement (1 ou 11), dans les répartiteurs réciproquement voisins, qu'une découpe adaptée aux dimensions de l'élément guide-fil étant prévue dans chaque paroi latérale d'un capot de fermeture.

8. Distributeur comportant un élément guide-fil suivant la revendication 1, caractérisé par le fait que sur la surface inférieure de paroi (23) sont formés par moulage au moins deux tétons de guidage (13), qui sont décalés latéralement l'un par rapport à l'autre en fonction du profil préformé et, dans leur position finale, s'engagent au-dessous du bord.

9. Répartiteur comportant un élément guide-fil suivant la revendication 1, caractérisé par le fait qu'une partie conformée (17) en forme de crochet, qui est dirigée au moins approximativement verticalement vers le haut, est formée dans la partie arrière de l'élément guide-fil.

10. Répartiteur comportant un élément guide-fil suivant l'une des revendications précédentes, caractérisé par le fait que l'élément de paroi avant (20) est utilisé en outre pour l'application d'une inscription.

## Claims

1. Distributor unit with wire guiding element (2) for telecommunication systems, the distributor unit comprising an elongate and substantially U-shaped carrier part (1) which serves for receiving the terminal strips (6, 7) for connecting and joining outgoing and incoming lines and which for its part is brought into a ready-to-use installation state, with the long sides in vertical alignment, by means of a retaining element which can be secured to it, and it being possible for there to be an extension by at least one identical distributor unit, to be attached laterally, and line leads running between distributor units respectively arranged in such a neighbouring fashion, and a separate cover hood (11) being adapted to fit onto each distributor unit, characterized in that the wire guiding element is designed as a plastic part and, for forming a transverse channel between two directly neighbouring distributor units, represents a hollow body which is open on two opposite sides and whose lower wall region (23) has outwardly pointing guide pegs (13), by which it can be fitted directly onto the end edge of each leg of the forwardly open carrier part (1) and in that, with the aid of fastening elements (17, 18) attached on the rear side, a mechanical connection takes place with the retaining element (3) protruding beyond the carrier part (1) in the longitudinal direction.

2. Distributor unit with wire guiding element according to Claim 1, characterized in that, as the fastening element, there is provided on the rear side a hook-like formation (17), which continues in a finger-like, resilient tab (18), in that in the region of each leg of the carrier part (1) a cutout (24) is provided on the plate (3) serving as the retaining element, in that, for the mechanical connection, the hook-shaped formation (17) embraces the lower edge of the cutout (24) and the resilient tab snaps into the cutout underneath the upper edge of the cutout (24).

3. Distributor unit with wire guiding element according to Claim 2, characterized in that an outwardly pointing rib (19) is moulded on in the end region of the resilient tab (18).

4. Distributor unit with wire guiding element according to Claim 1 or 2, characterized in that, after fastening, the said element is aligned with its open sides in the direction of the mutually neighbouring distributor units and in that the said element has on the wall face (20) accessible from the front a slot (14) pointing in this direction.

5. Distributor unit with wire guiding element according to Claims 1 and 4, characterized in that the hollow body has a rectangular cross-section and in that the slot (14) is provided in the region of the upper edge of the abutting upper wall part (21) and front wall part (20).

6. Distributor unit with wire guiding element according to Claim 5, characterized in that, for forming the said slot (14), the upper part of the front wall face points obliquely inwards in the direction of the upper side (21).

7. Distributor unit with wire guiding element according to one of the preceding claims, characterized in that it has in this transverse direction, determined by the open sides, an extent such that it engages at least beyond the lateral limits respectively predetermined by a cover hood (11) into the mutually neighbouring distributor units, a cutout adapted to the dimensions of the wire guiding element being provided in each side wall of a cover hood.

8. Distributor unit with wire guiding element according to Claim 1, characterized in that at least two guide pegs (13) are moulded on the lower wall face (23), which pegs are laterally offset with respect to each other in a manner corresponding to the preshaped profile and in the end position of the latter embrace the edge.

9. Distributor unit with wire guiding element according to Claim 1, characterized in that a hook-shaped and approximately vertically upward-pointing formation (16) is formed in its rear region.

10. Distributor unit with wire guiding element according to one of the preceding claims, characterized in that the front wall part (20) additionally serves for the provision of an inscription.
